# EUROPEAN PATENT APPLICATION

(11) **EP 3 447 579 A1**
(43) Date of publication of application: **27.02.2019**
(21) Application number: 18188828.0
(22) Date of filing: 14.08.2018
(51) Int. Cl.: G03F 7/095, G03F 7/00, B41J 2/16, G03F 7/004

(54) **THREE-DIMENSIONAL STRUCTURE, METHOD FOR MAKING THREE-DIMENDIONAL STRUCTURE, AND FLUID EJECTION DEVICE**

(30) Priority: 21.08.2017 US 201715682464
(71) Applicant: Funai Electric Co., Ltd., Daito, Osaka, 574-0013 (JP)
(72) Inventor: CRAFT, Christopher A., Lexington, KY 40511 (US); GRAHAM, David C., Lexington, KY 40511 (US)
(74) Representative: Becker Kurig Straus

(57) **Abstract**

A three-dimensional ("3D") structure for handling fluids, a fluid handling device containing the 3D structure, and a method of making the 3D structure are provided. The three-dimensional structure includes a composite film layer. The composite film layer includes a first photoresist layer and at least a second photoresist layer. The first photoresist layer includes a first photoacid generator therein having at least a first radiation exposure wavelength. The second photoresist layer includes a second photoacid generator therein having a second radiation exposure wavelength that is different from the first radiation exposure wavelength. The composite film layer is devoid of an adhesion promotion layer between the first photoresist layer and the second photoresist layer.

## Description

### TECHNICAL FIELD:

The disclosure relates to MEMS and nano devices, and in particular to improved methods for making three-dimensional photoimaged structures from a composite photoresist film containing multiple photoacid generators.

### BACKGROUND:

Micro-electromechanical systems ("MEMS") and nano-devices typically include three-dimensional ("3D") structures made from photoimaged materials. Examples of MEMS and nano-devices, include, but are not limited to fluid ejection heads, micro-filters, micro-separators, micro-sieves and other micro and nano scale fluid handling structures. Such structures may handle a wide variety of fluids. For example, fluid ejection heads are 3D nano devices that are useful for ejecting a variety of fluids including inks, cooling fluids, pharmaceuticals, lubricants and the like. A widely used fluid ejection head is in an ink jet printer. However, fluid ejection heads may also be used in vaporization devices for vapor therapy, E-cigarettes and the like. New techniques are constantly being developed to provide low cost, highly reliable fluid ejection heads for such devices.

The fluid ejection head is a seemingly simple device that has a relatively complicated structure containing electrical circuits, ink passageways and a variety of tiny parts assembled with precision to provide a powerful, yet versatile fluid ejection head. The components of the ejection head must cooperate with each other and be useful for a variety of fluids and fluid formulations. Accordingly, it is important to match the ejection head components to the fluid being ejected. Slight variations in production quality can have a tremendous influence on the product yield and resulting ejection head performance.

The primary components of a fluid ejection head are a semiconductor substrate, a flow feature layer, a nozzle plate layer, and a flexible circuit attached to the substrate. The semiconductor substrate is preferably made of silicon and contains various passivation layers, conductive metal layers, resistive layers, insulative layers and protective layers deposited on a device surface thereof. Fluid ejection actuators formed on a device surface of the substrate may be thermal actuators or piezoelectric actuators. For thermal actuators, individual heater resistors are defined in the resistive layers and each heater resistor corresponds to a nozzle hole in the nozzle plate for heating and ejecting fluid from the ejection head toward a desired substrate or target.

Current methods used to make the fluid flow layer and nozzle plate layer involve the use the combination of spin on photoresist or dry film photoresist with multiple image, develop, and bake steps for each layer. For example, in a conventional process, a first adhesion promotion layer is applied to a semiconductor substrate, a fluid flow layer of photoimageable material is spin coated onto the adhesion layer. The fluid flow layer is a negative photo resist layer that is imaged, cured, and developed. A second adhesion promotion layer is applied to the fluid flow layer before applying a nozzle layer. Next the nozzle layer is laminated as a dry film to the fluid flow layer by means of the second adhesion promotion layer. The nozzle layer is imaged, cured and developed. The semiconductor substrate is then deep reactive ion etched (DRIE) to form vias through the substrate. Since the fluid flow layer and nozzle layer are already attached to the substrate, the process latitude for the DRIE process is limited.

In an alternative process, the semiconductor substrate is first etched to form vias using the DRIE process before or after an adhesion promotion layer is applied to the substrate. Then the fluid flow layer and nozzle layer are applied to the substrate as dry films that are each imaged and developed. Each dry film requires a separate adhesion promotion layer. There is a risk of adhesion loss between layers with the application of each additional adhesion promotion layer.

In a variation of the alternative process, the DRIE process is conducted after the fluid flow layer is applied to the substrate and is imaged and developed. Subsequent to the DRIE process, the nozzle layer is laminated to the fluid flow layer and is imaged and developed.

Regardless of the process used, the use of multiple layers requiring multiple adhesion promotors increases the process time for making the fluid ejection heads and increases the risk of loss due to adhesion layer failure. Accordingly, what is needed is a simplified photoimageable process that reduces production time and the risk of adhesion layer failure.

### SUMMARY

The disclosure provides a three-dimensional ("3D") structure for handling fluids, a fluid handling device containing the 3D structure, and a method of making the 3D structure. In one embodiment, there is provided a three-dimensional structure including a composite film layer. The composite film layer includes: a first photoresist layer having a first photoacid generator therein having at least a first radiation exposure wavelength; and at least a second photoresist layer having a second photoacid generator therein having a second radiation exposure wavelength that is different from the first radiation exposure wavelength, and wherein the composite film layer is devoid of an adhesion promotion layer between the first photoresist layer and the second photoresist layer.

In another embodiment, there is provided a method of making a three-dimensional structure from a composite film layer. The method includes: applying a first photoresist layer to a carrier film, the first photoresist layer containing a first photoacid generator having at least a first radiation exposure wavelength; drying the first photoresist layer to provide a dried first photoresist layer; applying a second photoresist layer to the dried first photoresist layer, the second photoresist layer containing a second photoacid generator having a second radiation exposure wavelength that is different from the first radiation exposure wavelength; drying the second photoresist layer to provide a dried second photoresist layer, wherein the dried first photoresist layer and the dried second photoresist layer forms the composite film layer devoid of intermediate adhesion layer(s); laminating the composite film layer to a surface of a substrate; exposing the composite film layer to a first radiation exposure wavelength selected from a group consisting of e-line, g-line, h-line, i-line, mid ultraviolet, and deep ultraviolet; exposing the composite film layer to at least a second radiation exposure wavelength selected from a group consisting of e-line, g-line, h-line, i-line, mid ultraviolet, and deep ultraviolet; and simultaneously developing the composite film layer to provide the three-dimensional structure.

Another embodiment of the disclosure provides a fluid ejection device having a fluid ejection head and a controller. The fluid ejection head includes: a semiconductor substrate containing a plurality of fluid ejection actuators on a device surface thereof and one or more fluid supply vias etched therethrough; an adhesion promotion layer applied to the device surface of the semiconductor substrate; a composite film layer disposed on the adhesion promotion layer, wherein the composite film layer contains: a first photoresist layer having a first photoacid generator therein having at least a first radiation exposure wavelength, and at least a second photoresist layer having a second photoacid generator therein having a second radiation exposure wavelength that is different from the first radiation exposure wavelength, wherein the composite film layer is devoid of an adhesion promotion layer between the first photoresist layer and the second photoresist layer. The controller is for activating the fluid ejection head.

In some embodiments, the composite film layer includes at least a third photoresist layer, wherein the third photoresist layer has a third photoacid generator therein having a third radiation exposure wavelength that is different from the first and second radiation exposure wavelengths.

In other embodiments, the third photoresist layer of photoresist material has the first photoacid generator therein having a third radiation exposure wavelength that is different from the first and second radiation exposure wavelengths.

In some embodiments, the composite film layer has a thickness ranging from about 6 µm to about 150 µm.

In some embodiments, the first radiation exposure wavelength may be selected from a group consisting of e-line, g-line, h-line, i-line, mid ultraviolet, and deep ultraviolet. And, the second radiation exposure wavelength may be selected from a group consisting of e-line, g-line, h-line, i-line, mid ultraviolet, and deep ultraviolet. And, the second radiation exposure wavelength has a wavelength that is different from the first radiation exposure wavelength.

In some embodiments, the third radiation exposure wavelength (or subsequent exposure radiation wavelengths) may be selected from a group consisting of e-line, g-line, h-line, i-line, mid ultraviolet, and deep ultraviolet. And, the third radiation exposure wavelength has a wavelength that is different from the first and second radiation exposure wavelengths.

An advantage of the embodiments described herein is that the process steps for making 3D MEMS or nano devices are greatly simplified as described in more detail below, and provides 3D MEMS or nano devices in higher yields due to a decrease in lamination adhesion failures.

### BRIEF DESCRIPTION OF THE DRAWINGS:

Further features and advantages of the disclosed embodiments will become apparent by reference to the detailed description when considered in conjunction with the figures, which are not to scale, wherein like reference numbers indicate like elements through the several views, and wherein:

FIGS. 1-2 are flow diagrams of prior art process steps for making a fluid ejection head;

FIG. 3 is a flow diagram of process steps for making an ejection head according to an embodiment of the disclosure;

FIG. 4A is a schematic cross-sectional view, not to scale of a portion of a fluid ejection head according to the disclosure;

FIG. 4B is a plan schematic view, not to scale, of a portion of the fluid ejection head of FIG. 4A;

FIG. 5 is a cross-sectional view, not to scale, of a double-layer photoresist material according to an embodiment of the disclosure;

FIGS. 6-8 are schematic views, not to scale, of steps for making a fluid ejection head according to an embodiment of the disclosure;

FIG. 9 is a cross-sectional view, not to scale, of a triple-layer photoresist material according to an embodiment of the disclosure.

### DETAILED DESCRIPTION OF THE EMBODIMENTS:

With regard to embodiments of the disclosure, various MEMS and nano devices may be made having the desired composite film structure. An example of such a device is a fluid ejection head. Accordingly, for simplification purposes, the description is directed specifically to fluid ejection heads. However, the embodiments described herein may be adapted for use in making a wide variety of 3D MEMS and nano devices as referenced above.

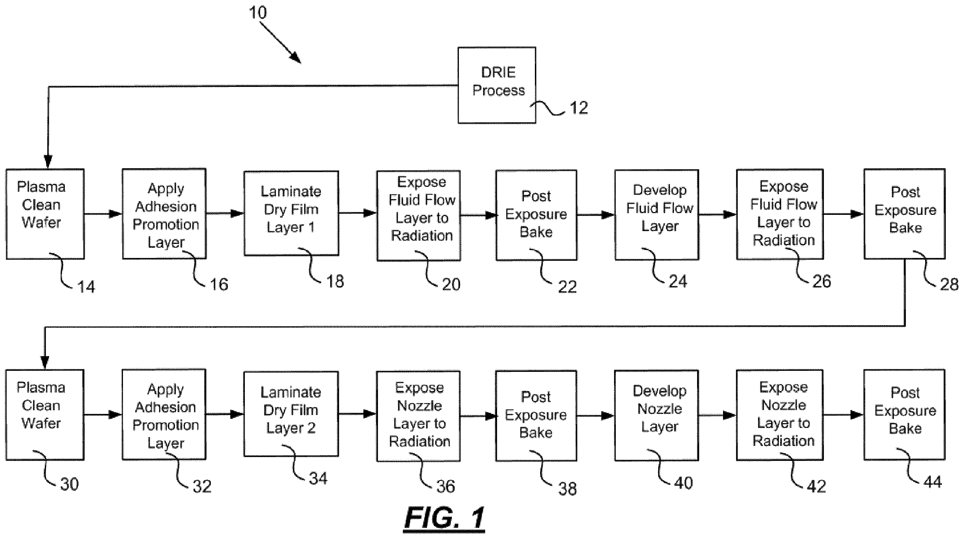

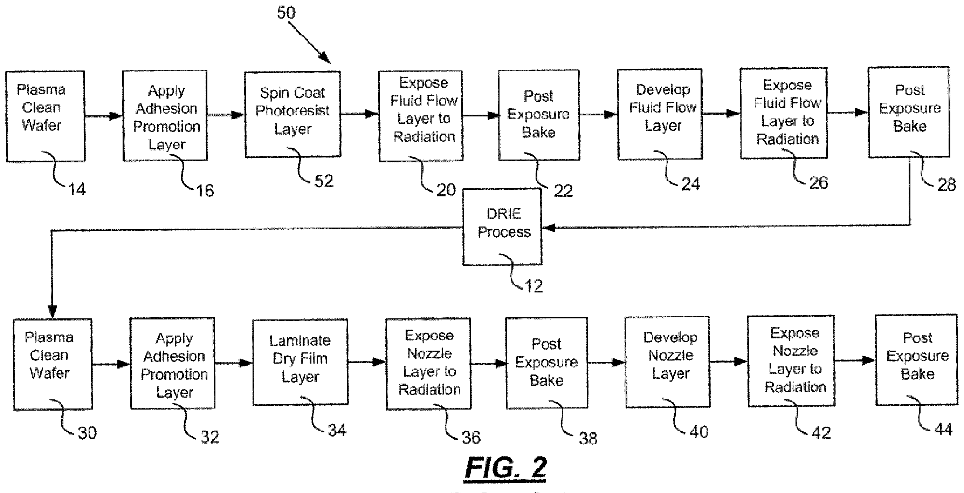

FIGS. 1 and 2, graphically illustrate block flow diagrams 10 and 50 of prior art process steps for making an ejection head. With reference to FIG. 1, the first step is a DRIE process 12 to etch fluid vias through a semiconductor substrate. Next, the substrate is plasma cleaned in step 14 and an adhesion promotion layer is applied to the substrate in step 16. A dry film layer that provides a fluid flow layer is applied to the adhesion layer in step 18. The fluid flow layer is exposed to radiation through a mask in step 20, and baked in step 22 to cure the exposed areas of the layer. Next the fluid flow layer is developed in step 24 to remove the masked areas of the fluid flow layer. The fluid flow layer is then exposed to ultraviolet (UV) radiation in step 26 and baked again in step 28 to remove any residual, photoacid generator, developer and/or uncured resin. The semiconductor substrate and fluid flow layer are plasma cleaned in step 30 and a second adhesion promotion layer is applied in step 32. A second dry film layer is laminated to the fluid flow layer in step 34 to provide a nozzle layer. The nozzle layer is exposed to radiation in step 36 to form nozzle holes in the nozzle layer. A second post exposure bake is performed in step 38 to cure the unmasked material in the nozzle layer. Next the nozzle layer is developed in step 40 to form the nozzle holes. The nozzle layer is exposed to UV radiation in step 42 and post exposure baked in step 44.

The primary differences between block flow diagram 10 and block flow diagram 50 is that in block flow diagram 10, the DRIE process to form vias in the semiconductor substrate is conducted before any of the flow layers are applied to the substrate, whereas in block flow diagram 50, the DRIE process is conducted after the fluid flow layer is applied to the substrate, exposed to radiation and developed. Since the semiconductor substrate does not already contain fluid vias, the fluid flow layer may be spin-coated onto the substrate in step 52 rather than laminated to the adhesion layer. Otherwise, the process steps are similar to those described with reference to FIG. 1.

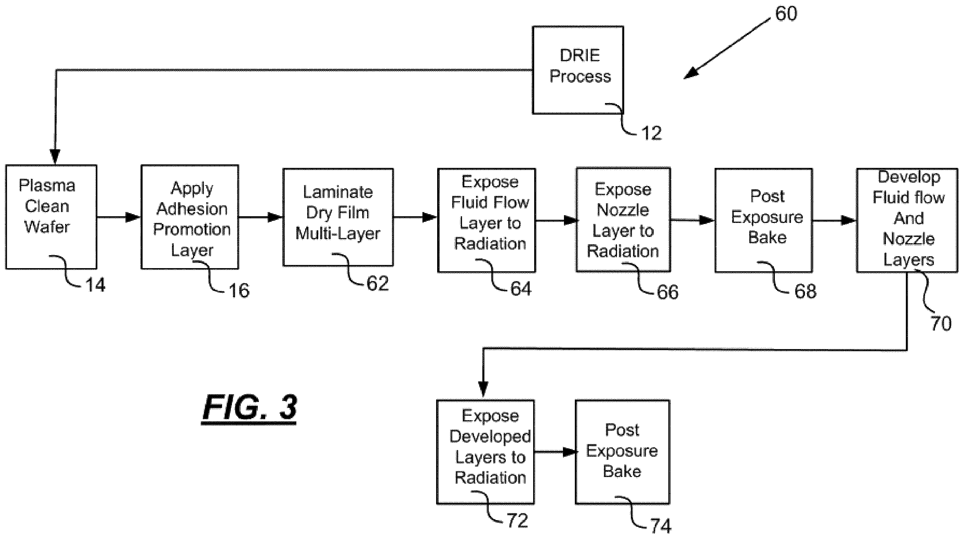

A block flow diagram 60 of simplified process according to an embodiment of the disclosure is shown in FIG. 3. The first three steps of the process of the block flow diagram 60 are similar to the first three steps of the prior art process of the block flow diagram 10. However, instead of laminating a single fluid flow layer to the substrate, a composite dry film layer is laminated in step 62 to the adhesion promotion layer. Next, the composite dry film layer is exposed to a first radiation source in step 64 through a mask to provide fluid flow features in the composite dry film layer. Prior to developing the fluid flow features, the composite dry film layer is exposed to a second radiation source through a second mask in step 66 to provide nozzle holes in the composite dry film layer. The composite dry film layer is then baked in step 68 to cure the masked areas of the composite dry film layer. In step 70, the composite dry film layer is developed to form fluid flow features and nozzle holes in the composite dry film layer. As in the prior art processes, the composite film layer is then exposed to UV radiation in step 72 and baked in step 74.

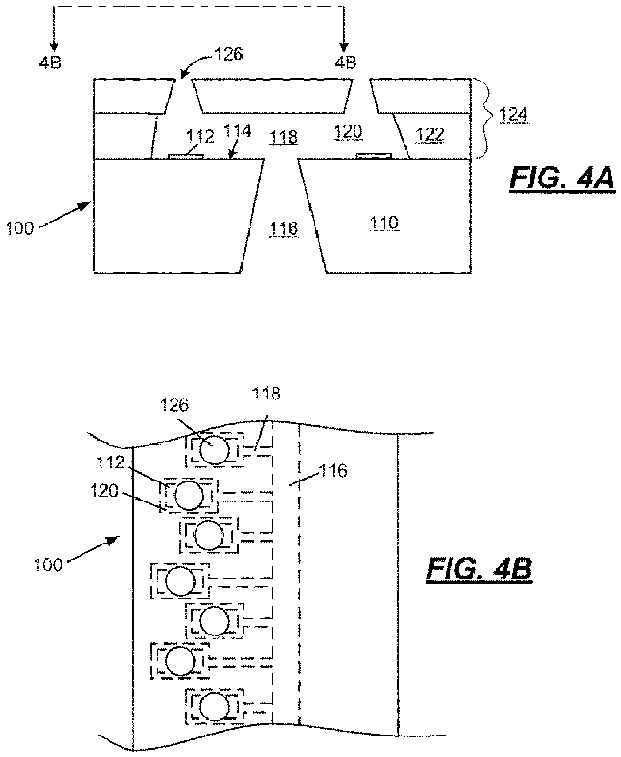

A portion of an ejection head 100 made by the foregoing process is illustrated in FIGS. 4A and 4B. The ejection head 100 includes a semiconductor substrate 110 that is preferably a silicon semiconductor substrate containing a plurality of fluid ejection actuators such as piezoelectric devices or heater resistors 112 formed on a device surface 114 of the semiconductor substrate 110. Upon activation of heater resistors 112, fluid supplied through one or more fluid supply vias 116 in the semiconductor substrate 110 flows through a fluid supply channel 118 to a fluid chamber 120 in a portion 122 of the composite film layer 124 where the fluid is caused to be ejected through nozzle holes 126 in the composite film layer 124. Fluid ejection actuators, such as heater resistors 112, are formed on the device surface 114 of the semiconductor substrate 110 by well-known semiconductor manufacturing techniques.

The semiconductor substrate 110 is relatively small in size and typically has overall dimensions ranging from about 2 to about 8 millimeters wide, from about 10 to about 20 millimeters long, and from about 0.4 to about 0.8 mm thick. In conventional semiconductor substrates 110, the fluid supply vias 116 are grit-blasted in the semiconductor substrates 110. Such fluid supply vias 116 typically have dimensions of about 9.7 millimeters long and from about 50 to about 400 microns wide. Fluid may be provided to the fluid ejection actuators by a single one of the fluid supply vias 116 or by a plurality of openings in the semiconductor substrate 110 made by a dry etch process selected from reactive ion etching (RIE) or deep reactive ion etching (DRIE), inductively coupled plasma etching, and the like. The composite film layer 124 may be formed from one or more layers of negative photoresist material as described in more detail below. The composite film layer 124 may have a thickness ranging from about 6 to about 150 µm or more, such as from about 10 to about 80 µm.

The fluid supply via 116 directs fluid from a fluid reservoir to which the ejection head 100 is attached through the fluid supply via 116 to the device surface 114 of the semiconductor substrate 110 containing heater resistors 112. The device surface 114 of the semiconductor substrate 110 also preferably contains electrical tracing from the heater resistors 112 to contact pads used for connecting the semiconductor substrate 110 to a flexible circuit or a tape automated bonding (TAB) circuit for supplying electrical impulses from a fluid ejection controller to activate one or more heater resistors 112 on the semiconductor substrate 110.

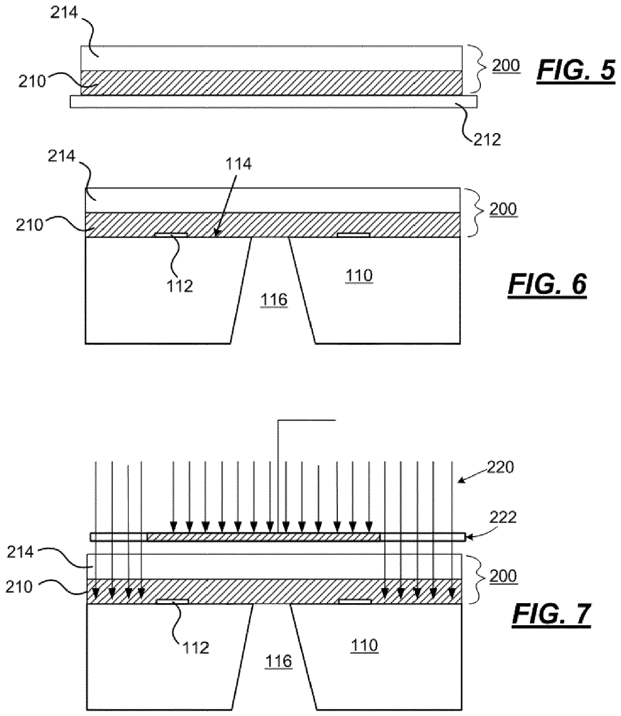

With reference to FIG. 5, there is illustrated a composite film layer 200 attached to a carrier film 212. The composite film layer 200 includes a first photoresist layer 210 that is formulated to contain a first photoacid generator having at least a first radiation exposure wavelength. The wavelength of the photoacid generator in the first photoresist layer 210 may be selected from e-line, g-line, h-line, i-line, mid UV, and deep UV radiation. The first radiation exposure wavelength, in some embodiments, may be greater than 350 nm. The thickness of the first photoresist layer 210 may range from about 3 µm to about 50 µm.

The composite film layer 200 may also contain a second photoresist layer 214 that is formulated to contain a second photoacid generator having a second radiation exposure wavelength that is different from the first radiation exposure wavelength. The second radiation exposure wavelength may be selected from e-line, g-line, h-line, i-line, mid UV, and deep UV radiation. In some embodiments, the second radiation exposure wavelength may be less than 350 nm. The second photoresist layer 214 may have a thickness ranging from about 3 to about 100 µm.

The wavelengths provided by the radiations sources that may be used according to embodiments of the disclosure are as follows:
e-line = 546 nm
g-line = 435 nm
h-line = 405 nm
i-line = 365 nm
mid UV = 310 nm
deep UV = 254 nm.

The photoresist materials that contain the photoacid generators may be formulated to include one or more of a multi-functional epoxy compound, a di-functional epoxy compound, a relatively high molecular weight polyhydroxy ether, an adhesion enhancer, and an aliphatic ketone solvent. For purposes of the disclosure, "difunctional epoxy" means epoxy compounds and materials having only two epoxy functional groups in the molecule. "Multifunctional epoxy" means epoxy compounds and materials having more than two epoxy functional groups in the molecule.

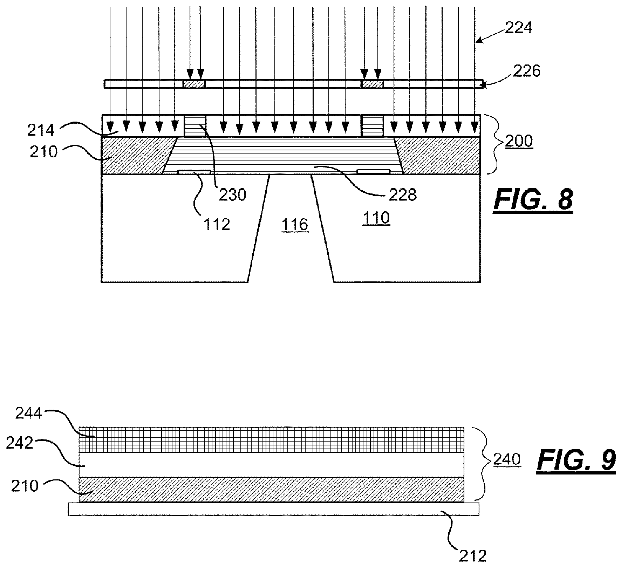

A suitable multifunctional epoxy component for making a photoresist formulation used for the composite film layer 200 or 240 (FIG. 9) according to one embodiment of the disclosure, may be selected from aromatic epoxides such as glycidyl ethers of polyphenols. An exemplary first multi-functional epoxy resin is a polyglycidyl ether of a phenolformaldehyde novolac resin such as a novolac epoxy resin having an epoxide gram equivalent weight ranging from about 190 to about 250 and a viscosity at 130° C. ranging from about 10 to about 60.

The multi-functional epoxy component of the photoresist formulation may have a weight average molecular weight of about 3,000 to about 5,000 Daltons as determined by gel permeation chromatography, and an average epoxy group functionality of greater than 3, preferably from about 6 to about 10. The amount of multifunctional epoxy resin in an exemplary photoresist formulation may range from about 30 to about 50 percent by weight based on the weight of the cured thick film layer.

The di-functional epoxy component may be selected from di-functional epoxy compounds which include diglycidyl ethers of bisphenol-A, 3,4-epoxycyclohexylmethyl-3,4-epoxycyclo-hexene carboxylate, 3,4-epoxy-6-methylcyclohexylmethyl-3,4-epoxy-6-methyl-cyclohexene carboxylate, bis(3,4-epoxy-6-methylcyclohexylmethyl) adipate, and bis(2,3-epoxycyclopentyl) ether.

An exemplary di-functional epoxy component is a bisphenol-A/epichlorohydrin epoxy resin having an epoxide equivalent of greater than about 1000. An "epoxide equivalent" is the number of grams of resin containing 1 gram-equivalent of epoxide. The weight average molecular weight of the first di-functional epoxy component is typically above 2500 Daltons, e.g., from about 2800 to about 3500 weight average molecular weight. The amount of the first di-functional epoxy component in the photoresist formulation may range from about 30 to about 50 percent by weight based on the weight of the cured resin.

Exemplary photoacid generators include compounds or mixture of compounds capable of generating a cation such as an aromatic complex salt which may be selected from onium salts of a Group VA element, onium salts of a Group VIA element, and aromatic halonium salts. Aromatic complex salts, upon being exposed to ultraviolet radiation or electron beam irradiation, are capable of generating acid moieties which initiate reactions with epoxides. The photoacid generator may be present in the photoresist formulation in an amount ranging from about 5 to about 15 weight percent based on the weight of the cured resin.

Compounds that generate a protic acid when irradiated by active rays, may be used as the photoacid generator, including, but are not limited to, aromatic iodonium complex salts and aromatic sulfonium complex salts. Examples include di-(t-butylphenyl)iodonium triflate, diphenyliodonium tetrakis(pentafluorophenyl)borate, diphenyliodonium hexafluorophosphate, diphenyliodonium hexafluoroantimonate, di(4-nonylphenyl)iodonium hexafluorophosphate, [4-(octyloxy)phenyl]phenyliodonium hexafluoroantimonate, triphenylsulfonium triflate, triphenylsulfonium hexafluorophosphate, triphenylsulfonium hexafluoroantimonate, triphenylsulfonium tetrakis(pentafluorophenyl)borate, 4,4'-bis[diphenylsulfonium]diphenylsulfide, bis-hexafluorophosphate, 4,4'-bis[di([beta]-hydroxyethoxy)phenylsulfonium]diphenylsulfide bis-hexafluoroantimonate, 4,4'-bis[di([beta]-hydroxyethoxy)(phenylsulfonium)diphenyl sulfide-bishexafluorophosphate, 7-[di(p-tolyl)sulfonium]-2-isopropylthioxanthone hexafluorophosphate, 7-[di(p-tolyl)sulfonio-2-isopropylthioxanthone hexafluoroantimonate, 7-[di(p-tolyl)sulfonium]-2-isopropyl tetrakis(pentafluorophenyl)borate, phenylcarbonyl-4'-diphenylsulfonium diphenylsulfide hexafluorophosphate, phenylcarbonyl-4'-diphenylsulfonium diphenylsulfide hexafluoroantimonate, 4-tert-butylphenylcarbonyl-4'-diphenylsulfonium diphenylsulfide hexafluorophosphate, 4-tert-butylphenylcarbonyl-4'-diphenylsulfonium diphenylsulfide hexafluoroantimonate, 4-tert-butylphenylcarbonyl-4'-diphenylsulfonium diphenylsulfide tetrakis(pentafluorophenyl)borate, diphenyl [4-(phenylthio)phenyl]sulfonium hexafluoroantimonate and the like.

The photoresist formulation may optionally include an effective amount of an adhesion enhancing agent such as a silane compound. Silane compounds that are compatible with the components of the photoresist formulation typically have a functional group capable of reacting with at least one member selected from the group consisting of the multifunctional epoxy compound, the difunctional epoxy compound and the photoinitiator. Such an adhesion enhancing agent may be a silane with an epoxide functional group such as a glycidoxyalkyltrialkoxysilane, e.g., gammaglycidoxypropyltrimethoxysilane. When used, the adhesion enhancing agent can be present in an amount ranging from about 0.5 to about 2 weight percent, such as from about 1.0 to about 1.5 weight percent based on total weight of the cured resin, including all ranges subsumed therein. Adhesion enhancing agents, as used herein, are defined to mean organic materials soluble in the photoresist composition which assist the film forming and adhesion characteristics of the composite film layer 200 or 240 adjacent the device surface 114 of the semiconductor substrate 110.

An exemplary solvent for use in the photoresist formulation is a solvent which is non-photoreactive. Non-photoreactive solvents include, but are not limited gamma-butyrolactone, C₁₋₆ acetates, tetrahydrofuran, low molecular weight ketones, mixtures thereof and the like. The non-photoreactive solvent is present in the formulation mixture used to provide the composite film layer 124 in an amount ranging from about 20 to about 90 weight percent, such as from about 40 to about 60 weight percent, based on the total weight of the photoresist formulation. In an exemplary embodiment, the non-photoreactive solvent does not remain in the cured composite film layer and is thus removed prior to or during the composite film layer curing steps.

A representative formulation for the first photoresist layer 210 and the second photoresist 214 is illustrated below in Table 1.

**Table 1**

| Component | First photoresist layer 210 (phr) | Second photoresist layer 214 (phr) |
|---|---|---|
| Methyl ethyl ketone solvent | balance | balance |
| Photoacid generator 1 | 3.5 | ---- |
| Photoacid generator 2 | ---- | 3.5 |
| gamma-Butyrolactone solvent | 3.5 | 3.5 |
| Powder-grade phenoxy resin | 40 | 40 |
| Phenol-formaldehyde resin | 30 | 30 |
| Naphthalene epoxy resin | 30 | 30 |
| Thioxanthenone photoinitiator | 0.5 | 0.5 |
| Green Solvent Metal Complex Dye | 0.25 | 0 |
| 3-(guanidinyl)propyltrimethoxysilane | 2.22 | 2.22 |

In order to provide the composite film layer 200, the first photoresist layer 210 of photoresist resin containing photoacid generator 1 may be coated onto the carrier film 212 and dried. Next the second photoresist layer 214 of photoresist resin containing photoacid generator 2 may be coated onto the first photoresist layer 210 and dried. The composite dry film layer 200 may then be removed from the carrier film 212 and laminated to the device surface 114 of the semiconductor substrate 110 as shown in FIG. 6 according to step 62 (FIG. 3).

With reference to FIG. 7, the first photoresist layer 210 may be exposed to e-line, g-line, h-line, i-line, mid UV, or deep UV radiation 220 through a mask 222 to provide formation of the flow features in the first photoresist layer 210 of the composite film layer 200. Next, as shown in FIG. 8, the second photoresist layer 214 of the composite film layer 200 is exposed to e-line, g-line, h-line, i-line, mid UV, or deep UV radiation 224 having a wavelength different from the first radiation exposure wavelength through a second mask 226 to provide the nozzle features in the second photoresist layer 214 of the composite film layer 200. FIG. 8 illustrates the undeveloped flow features 228 and undeveloped nozzle features 230 in the composite film layer 200.

After exposing the composite film layer 200 to radiation, the composite film layer 200 is heated to cross-link the photoresist material in the exposed areas thereof. A developer solvent is then applied to the semiconductor substrate 110 and composite film layer 200 to remove uncured photoresist material thereby forming the fluid supply channels 118 (FIGS. 4A-4B), fluid chambers 120, and nozzle holes 126 therein. In one embodiment, the semiconductor substrate 110 containing the radiation exposed composite film layer 200 is placed in a developer bath using megasonic agitation to dissolve the uncross-linked materials in both the first photoresist layer 210 and the second photoresist layer 214 so that the uncrosslinked material from the first photoresist layer 210 is dissolved through the previously formed fluid supply via 116 and the uncrosslinked material from the second photoresist layer 214 is dissolved to form the nozzle holes 126 in the second photoresist layer 214. Illustrative developers used in the developer bath include, for example, butyl cellosolve acetate, cyclohexanone, methyl ethyl ketone, a xylene and butyl cellosolve acetate mixture, and C₁₋₆ acetates like butyl acetate, or a combination of two or more of the foregoing. A third heating step at a temperature of about 200 °C for about 2 hours may be used to remove any residual photoacid generator that may be in the composite film layer 200.

In an alternative embodiment illustrated in FIG. 9, the composite film layer 240 may attached to the carrier film 212. The composite film layer 240 includes the first photoresist layer 210 that is formulated to contain the first photoacid generator having at least the first radiation exposure wavelength. The wavelength of the photoacid generator in the first photoresist layer 210 may be selected from e-line, g-line, h-line, i-line, mid UV, or deep UV radiation. The thickness of the first photoresist layer 210 may range from about 3 to about 50 µm. The composite film layer 240 may also contain a second photoresist layer 242 that is formulated to contain the second photoacid generator having the second radiation exposure wavelength. The second radiation exposure wavelength may include a radiation wavelength selected from e-line, g-line, h-line, i-line, mid UV, or deep UV radiation that is different from the first radiation exposure wavelength. The second photoresist layer 242 may have a thickness ranging from about 3 to 50 µm.

In one embodiment, a third photoresist layer 244 containing the first photoacid generator may be applied to the second photoresist layer 242. The wavelength of the photoacid generator in the third photoresist layer 244 may be selected from e-line, g-line, h-line, i-line, mid UV, or deep UV radiation with a wavelength that is different from the first and second radiation exposure wavelengths. In an alternative embodiment, the third photoresist layer 244 may include a third photoacid generator that has a wavelength selected from e-line, g-line, h-line, i-line, mid UV, or deep UV radiation with a wavelength that is different from the first and second radiation exposure wavelengths. The third photoresist layer 244 may have a thickness ranging from about 3 to about 50 µm.

Representative formulations for the first photoresist layer 210, the second photoresist layer 242 and the third photoresist layer 244 are illustrated below in Tables 2 and 3.

**Table 2**

| Component | First photoresist layer 210 (phr) | Second photoresist layer 242 (phr) | Third photoresist layer 244 (phr) |
|---|---|---|---|
| Methyl ethyl ketone solvent | balance | balance | balance |
| Photoacid generator 1 | 3.5 | ---- | 3.5 |
| Photoacid generator 2 | ---- | 3.5 | ---- |
| gamma-Butyrolactone solvent | 3.5 | 3.5 | 3.5 |
| Powder-grade phenoxy resin | 40 | 40 | 40 |
| Phenol-formaldehyde resin | 30 | 30 | 30 |
| Naphthalene epoxy resin | 30 | 30 | 30 |
| Thioxanthenone photoinitiator | 0.5 | 0.5 | 0.5 |
| Green Solvent Metal Complex Dye | 0.25 | 0 | 0.5 |
| 3-(guanidinyl)propyltrimethoxysilane | 2.22 | 2.22 | 2.22 |

**Table 3**

| Component | First photoresist layer 210 (phr) | Second photoresist layer 242 (phr) | Third photoresist layer 244 (phr) |
|---|---|---|---|
| Methyl ethyl ketone solvent | balance | balance | balance |
| Photoacid generator 1 | 3.5 | ---- | ---- |
| Photoacid generator 2 | ---- | 3.5 | ---- |
| Photoacid generator 3 | ---- | ---- | 3.5 |
| gamma-Butyrolactone solvent | 3.5 | 3.5 | 3.5 |
| Powder-grade phenoxy resin | 40 | 40 | 40 |
| Phenol-formaldehyde resin | 30 | 30 | 30 |
| Naphthalene epoxy resin | 30 | 30 | 30 |
| Thioxanthenone photoinitiator | 0.5 | 0.5 | 0.5 |
| Green Solvent Metal Complex Dye | 0.25 | 0 | 0 |
| 3-(guanidinyl)propyltrimethoxysilane | 2.22 | 2.22 | 2.22 |

The above formulations may also contain a phenoxy resin that may be added to the first photoresist layer 210 and/or the second photoresist layer 242 to increase the hydrophilicity of the first photoresist layer 210 and/or the second photoresist layer 242. Compounds that may be added to the first photoresist layer 210 and/or the second photoresist layer 242 to increase the hydrophobicity of layers may include, but are not limited to heptadecafluoro-decyltrimethoxysilane, octadecyldimethylchlorosilane, ocatadecyltricholorsilane, and siloxanes.

By using the composite film layers 200 and 240 described above, the use of multiple adhesion promotion steps for making the fluid ejection head may be avoided. Since the formulations of each layer are similar, except for the photoacid generator and small amount of green dye, the photoresist materials will mix and adhere to each other at the interface between the layers without the need for an adhesion promotion layer. The amount of green dye may be varied in the layers to further enhance the radiation wavelengths needed to image the layers.

While two and three layer composite films have been demonstrated above, the disclosure is not limited to two and three layer composite films. The disclosure is thus adaptable to making 3D MEMS and nano devices having three or more layers, wherein each layer may include a photoacid generator that enables each layer to be imaged with a different radiation wavelength or two or more layers may be imaged with the same radiation wavelength.

### DESCRIPTION OF REFERENCE SIGNS

10, 50, 60: block flow diagram
12: DRIE process
14, 16, 18, 20, 22, 24, 26, 28, 30, 32, 34, 36, 38, 40, 42, 44, 52, 62, 64, 66, 68, 70, 72, 74: step
100: ejection head
110: semiconductor substrate
112: piezoelectric devices or heater resistors
114: device surface
116: fluid supply via
118: fluid supply channel
120: fluid chamber
122: portion
124, 200, 240: composite film layer
126: nozzle hole
210: first photoresist layer
212: carrier film
214, 242: second photoresist layer
220, 224: e-line, g-line, h-line, i-line, mid UV, or deep UV radiation
222: mask
226: second mask
228: undeveloped flow features
230: undeveloped nozzle features
244 : third photoresist layer

## Claims

1. A three-dimensional structure (100), **characterized in that** the three-dimensional structure (100) comprising:
a composite film layer (124, 200, 240), comprising:
a first photoresist layer (210) having a first photoacid generator therein having at least a first radiation exposure wavelength; and
at least a second photoresist layer (214, 242) having a second photoacid generator therein having a second radiation exposure wavelength that is different from the first radiation exposure wavelength,
wherein the composite film layer (124, 200, 240) is devoid of an adhesion promotion layer between the first photoresist layer (210) and the second photoresist layer (214, 242).

2. The three-dimensional structure (100) of claim 1, wherein
the composite film layer (240) comprises at least a third photoresist layer (244).

3. The three-dimensional structure (100) of claim 2, wherein
the third photoresist layer (244) has a third photoacid generator therein having a third radiation exposure wavelength that is different from the first and second radiation exposure wavelengths.

4. The three-dimensional structure (100) of claim 2, wherein
the third photoresist layer (244) has the first photoacid generator therein having a third radiation exposure wavelength that is different from the first and second radiation exposure wavelengths.

5. The three-dimensional structure (100) of claim 2, wherein
the third photoresist layer (244) has the second photoacid generator therein having the second radiation exposure wavelength.

6. The three-dimensional structure (100) of any one of claims 1 to 5, wherein
the composite film layer (124, 200, 240) has a thickness ranging from about 6 µm to about 150 µm.

7. The three-dimensional structure (100) of any one of claims 1 to 6, wherein
the first radiation exposure wavelength is selected from a group consisting of e-line, g-line, h-line, i-line, mid ultraviolet, and deep ultraviolet.

8. The three-dimensional structure (100) of any one of claims 1 to 7, wherein
the second radiation exposure wavelength is selected from a group consisting of e-line, g-line, h-line, i-line, mid ultraviolet, and deep ultraviolet.

9. The three-dimensional structure (100) of claim 3, wherein
the third radiation exposure wavelength is selected from a group consisting of e-line, g-line, h-line, i-line, mid ultraviolet, and deep ultraviolet.

10. A method of making a three-dimensional structure (100) from a composite film layer (124, 200, 240), **characterized in that** the method comprising:
applying a first photoresist layer (210) to a carrier film (212), the first photoresist layer (210) containing a first photoacid generator having at least a first radiation exposure wavelength;
drying the first photoresist layer (210) to provide a dried first photoresist layer;
applying a second photoresist layer (214, 242) to the dried first photoresist layer, the second photoresist layer (214, 242) containing a second photoacid generator having a second radiation exposure wavelength that is different from the first radiation exposure wavelength;
drying the second photoresist layer (214, 242) to provide a dried second photoresist layer, wherein the dried first photoresist layer and the dried second photoresist layer forms the composite film layer (200) devoid of intermediate adhesion layer;
laminating the composite film layer (200) to a surface of a substrate (110);
exposing the composite film layer (200) to a first radiation exposure wavelength selected from a group consisting of e-line, g-line, h-line, i-line, mid ultraviolet, and deep ultraviolet;
exposing the composite film layer (200) to at least a second radiation exposure wavelength selected from a group consisting of e-line, g-line, h-line, i-line, mid ultraviolet, and deep ultraviolet;
simultaneously developing the composite film layer (200) to provide the three-dimensional structure (100).

11. The method of claim 10, further comprising:
applying a third photoresist layer (244) to the dried second photoresist layer to provide the composite film layer (240),
wherein the third photoresist layer (244) contains a third photoacid generator having a third radiation exposure wavelength that is different from the first and second radiation exposure wavelengths.

12. The method of claim 10, further comprising:
applying a third photoresist layer (244) to the dried second photoresist layer to provide the composite film layer (240),
wherein the third photoresist layer (244) contains the first photoacid generator therein having a third radiation exposure wavelength that is different from the first and second radiation exposure wavelengths.

13. The method of any one of claims 10 to 12, wherein
the composite film layer (200, 240) has a thickness ranging from about 6 µm to about 150 µm.

14. The method of claim 11 or claim 12, wherein
the third radiation exposure wavelength is selected from a group consisting of e-line, g-line, h-line, i-line, mid ultraviolet, and deep ultraviolet.

15. A fluid ejection device, **characterized in that** the fluid ejection device comprising:
a fluid ejection head (100), the fluid ejection head (100) comprising:
a semiconductor substrate (110) containing a plurality of fluid ejection actuators (112) on a device surface (114) thereof and one or more fluid supply vias (116) etched therethrough;
an adhesion promotion layer applied to the device surface (114) of the semiconductor substrate (110); and
a composite film layer (124, 200, 240) disposed on the adhesion promotion layer, wherein the composite film layer (124, 200, 240) comprising:
a first photoresist layer (210) having a first photoacid generator therein having at least a first radiation exposure wavelength; and
at least a second photoresist layer (214, 242) having a second photoacid generator therein having a second radiation exposure wavelength that is different from the first radiation exposure wavelength, wherein the composite film layer (124, 200, 240) is devoid of the adhesion promotion layer between the first photoresist layer (210) and the second
photoresist layer (214, 242); and
a controller for activating the fluid ejection head.
